# EUROPÄISCHE PATENTSCHRIFT

(11) **EP 3 321 623 B1**
(45) Veröffentlichungstag und Bekanntmachung des Hinweises auf die Patenterteilung: **27.11.2019**
(21) Anmeldenummer: 17197537.8
(22) Anmeldetag: 20.10.2017
(51) Int. Cl.: F28D 20/02, H05K 7/20

(54) **CHILLER MIT KOMPRESSIONSKÄLTEMITTELKREISLAUF UND PUFFERSPEICHER, EINE ENTSPRECHENDE KÜHLANORDNUNG SOWIE EIN ENTSPRECHENDES BETRIEBSVERFAHREN**
CHILLER WITH COMPRESSION COOLANT CIRCUIT AND BUFFER STORAGE, A CORRESPONDING COOLING ARRANGEMENT AND A METHOD FOR OPERATING SAME
REFROIDISSEUR DOTÉ D'UN CIRCUIT DE RÉFRIGÉRANT DE COMPRESSION ET D'UNE MÉMOIRE TAMPON, DISPOSITIF DE REFROIDISSEMENT CORRESPONDANT ET PROCÉDÉ DE FONCTIONNEMENT CORRESPONDANT

(30) Priorität: 14.11.2016 DE 102016121825
(43) Veröffentlichungstag der Anmeldung: 16.05.2018
(73) Patentinhaber: Rittal GmbH & Co. KG, 35745 Herborn (DE)
(72) Erfinder: Weber, Markus, 65428 Rüsselheim (DE); Prinz, Sebastian, 35606 Solms (DE); Nonn, Oliver, 57629 Malberg (DE)
(74) Vertreter: Angerhausen, Christoph

(56) Entgegenhaltungen:
- WO-A1-2014/032654
- DE-A1- 19 860 057
- DE-A1-102014 109 165
- US-B1- 7 505 269

## Beschreibung

Die Erfindung geht aus von einem Chiller für die Kühlung eines flüssigen Kühlmediums, wobei der Chiller einen Kompressionskältemittelkreislauf mit einem Verdichter, einem Verflüssiger, einem Expansionsventil und einem Verdampfer aufweist. Der Verdampfer ist ein Wärmeübertrager, über den ein Kältemittel des Kompressionskältemittelkreislaufs mit einem zu kühlenden flüssigen Kühlmedium fluidisch getrennt thermisch gekoppelt ist. Ein Ausgang des Wärmeübertragers für gekühltes, flüssiges Kühlmedium mündet in einen Pufferspeicher, wobei das gekühlte, flüssige Kühlmedium aus dem Pufferspeicher einem Kühlmediumauslass des Chillers zugeleitet ist. Ein derartiger Chiller wird beispielsweise für die Flüssigkeitskühlung von Maschinenkomponenten verwendet und von der Rittal GmbH & Co. KG unter der Handelsbezeichnung "TopTherm" vertrieben.

Ein Chiller mit den Merkmalen im Oberbegriff des Patentanspruchs 1 ist zum Beispiel aus der DE 198 60 057 A1 bekannt.

Die DE 10 2012 112 646 A1 beschreibt eine Kühlanordnung mit einem Wärmetauscher, dem ein Wärmetransportfluid zugeführt ist, wobei mittels des Wärmetauschers dem Wärmetransportfluid Wärme entzogen oder diesem zugeführt wird. Diese Wärme wird zumindest teilweise in einen Wärmeübertrager eingeleitet oder aus diesem entnommen, wobei der Wärmeüebrtrager in wärmeleitendem Kontakt mit einem Wärmespeicher steht. Der Wärmespeicher weist als wärmespeicherndes Material ein Phasenwechselmaterial ("PCM-Material") auf.

Die DE 10 2014 109 165 A1 offenbart einen Latentwärmespeicher, bei dem ein Phasenwechselmaterial in einer rohrförmigen Kapselung aufgenommen ist. Die rohrförmige Kapselung ist doppelwandig ausgeführt, wobei zwischen den beabstandeten Wänden der Kapselung ein flüssiges Wärmetransportmedium hindurchgeführt ist, um Wärme mit dem PCM-Material auszutauschen.

Die WO 2015/028896 A1 beschreibt eine Kühlanordnung, die einen Kompressionskältekreislauf aufweist und zu Redundanzzwecken einen zusätzlichen Pumpenkreislauf, der als PCM-Elemente ausgebildete Wärmesenken umfasst, so dass im Versagensfall des Kompressionskältemittelkreislaufs mit Hilfe des PCM-Materials Kühlleistung temporär bereitgestellt werden kann.

Die aus dem Stand der Technik bekannten Chiller, bei denen zur Verringerung der Taktfrequenz des Kompressionskältemittelkreislaufs gekühltes Kühlmedium in einem Kühlmediumtank bzw. Pufferspeicher vorgehalten wird, haben den Nachteil, dass sie aufgrund des erforderlichen Tankvolumens ein vergleichsweise großes Bauvolumen aufweisen. Als flüssiges Kühlmedium wird häufig Wasser oder Öl verwendet, welches wegen seiner gegebenen Wärmekapazität in einem bestimmten Mindestvolumen in dem Tank vorgehalten werden muss, um eine sinnvolle Absenkung der Taktrate des Kompressionskältemittelkreislaufs erreichen zu können. Die Außenabmessungen der aus dem Stand der Technik bekannten Chiller sind daher nicht beliebig verkleinerbar.

Es ist daher die Aufgabe der Erfindung, einen Chiller der eingangs beschriebenen Art derart weiterzuentwickeln, dass er möglichst kompakte Abmessungen aufweist.

Diese Aufgabe wird durch einen Chiller mit den Merkmalen des Anspruchs 1 gelöst. Der Anspruch 9 betrifft eine entsprechende Kühlanordnung und der Anspruch 10 ein Betriebsverfahren für einen derartigen Chiller. Die abhängigen Ansprüche betreffen jeweils vorteilhafte Ausführungsformen der Erfindung.

Demgemäß ist vorgesehen, dass ein PCM-Material in dem Pufferspeicher aufgenommen und das gekühlte, flüssige Kühlmedium in dem Pufferspeicher durch einen Wärmetauscher geleitet ist, über den das gekühlte, flüssige Kühlmedium mit dem PCM-Material thermisch gekoppelt ist.

Während somit einerseits die gängigen und in der Praxis etablierten Kühlmedien, wie etwa Wasser oder Öl, weiterhin verwendet werden können, nutzt die Erfindung die im Vergleich zu diesen Kühlmedien höhere Wärmekapazität von PCM-Materialien, indem in dem Pufferspeicher ein Wärmetauscher vorgesehen ist, der einen Wärmeabtausch zwischen dem in dem Pufferspeicher vorgehaltenen PCM-Material und dem gekühlten, flüssigen Kühlmedium bereitstellt. Unter Beibehaltung der bekannten Baugrößen des Pufferspeichers kann somit die Taktrate des Kompressionskältemittelkreislaufs weiter abgesenkt werden, wodurch die aktiven Komponenten des Kompressionskältemittelkreislaufs geschont und sich damit die Haltbarkeit des Kompressionskältemittelkreislaufs erhöht. Im Umkehrschluss ist es jedoch auch möglich, unter Beibehaltung der gängigen Taktraten des Kompressionskältemittelkreislaufs das Volumen des Pufferspeichers zu verringern und damit die äußeren Baumaße des Chillers.

Der Wärmetauscher kann beispielsweise ein Lamellen- oder Plattenwärmetauscher mit einem Rohrleitungssystem sein, durch das das gekühlte, flüssige Kühlmedium geleitet ist, wobei das PCM-Material den Lamellen- oder Plattenwärmetauscher thermisch leitend umgibt.

Es ist auch denkbar, das PCM-Material als mehrere PCM-Materialkapseln bereitzustellen, mit jeweils einem PCM-Materialkern, der von einem doppelwandigen und von dem Kühlmedium durchströmten Rohrmantel vollständig umschlossen ist. Ein derartiges, gekapseltes PCM-Material ist beispielsweise aus der DE 10 2014 109 165 A1 bekannt. Wenn das PCM-Material als mehrere PCM-Materialkapseln bereitgestellt ist, können die Rohrmäntel der mehreren PCM-Materialkapseln fluidisch in Reihe oder parallel geschaltet sein.

Der Wärmetauscher in dem Pufferspeicher kann ein Lamellen- oder Plattenwärmetauscher mit parallel beabstandeten Wärmetauscherlamellen oder -platten sein, wobei der Wärmetauscher von einem Rohrleitungssystem durchsetzt ist, durch das das Kühlmedium geleitet ist. Das PCM-Material kann in Hohlräumen zwischen den Lamellen oder Platten aufgenommen und/oder die Lamellen oder Platten hohl ausgebildet sein, mit zwischen gegenüber liegenden Wandungen eingeschlossenem PCM-Material.

Der Wärmetauscher in dem Pufferspeicher kann von einem Rohrleitungssystem durchsetzt sein, durch das das Kühlmedium geleitet ist, wobei das Rohrleitungssystem an gegenüber liegenden Außenseiten des Wärmetauschers jeweils einen Kühlmediumvorlauf aufweist. Die Kühlmediumvorläufe können über jeweils einen ersten Rohrleitungsabschnitt des Rohrleitungssystems mäanderförmig von den Außenseiten zu einem zentralen Kernbereich des Wärmetauschers geführt sein.

Dabei können die beiden ersten Rohrleitungsabschnitte jeweils über den zentralen Kernbereich hinweg mäanderförmig bis zu der jeweils gegenüber liegenden Außenseite geführt sein, wobei sie jeweils über Verbindungsleitungen mit einem zweiten Rohrleitungsabschnitt des Rohrleitungssystems im Kernbereich des Wärmetauschers verbunden sind. Dabei können die beiden ersten Rohrleitungsabschnitte den Kernbereich mittels Sprungleitungen überbrücken, so dass sie mit im Kernbereich angeordnetem PCM-Material nicht in thermischem Kontakt stehen.

Der zweite Rohrleitungsabschnitt kann eine zentrale Zuleitung aufweisen, in die die Verbindungsleitungen münden, wobei der zweite Rohrleitungsabschnitt ausgehend von der zentralen Zuleitung mäanderförmig in Richtung der gegenüber liegenden Außenseite geführt ist.

An gegenüber liegenden Außengrenzen des Kernbereichs kann jeweils ein Ausgang des zweiten Rohrleitungsabschnitts über jeweils eine weitere Verbindungsleitung mit einem Rücklauf des Wärmetauschers verbunden sein.

Eine Schaltschrankanordnung kann einen Chiller der zuvor beschrieben Art sowie ein Schaltschrankgehäuse mit mindestens einem Baugruppeneinschub, insbesondere mindestens einem 19"-Einschub, aufweisen, wobei der Pufferspeicher mindestens ein in einen der Baugruppeneinschübe eingeschobenes und wahlweise daraus wieder entnehmbares Einschubgehäuse ist, in dem der Wärmetauscher und das PCM-Material (12) aufgenommen sind.

Das mindestens eine Einschubgehäuse, insbesondere der Wärmetauscher (13), kann in einer Einschubposition, in der das Einschubgehäuse vollständig in den Baugruppeneinschub eingeschoben ist, einen Vorlauf und einen Rücklauf für das gekühlte, flüssige Kühlmedium fluidisch kontaktieren.

Das Schaltschrankgehäuse kann mehrere vertikal übereinander und/oder horizontal nebeneinander angeordnete Baugruppeneinschübe und mehrere darin aufgenommene Einschubgehäuse aufweisen, wobei die Baugruppeneinschübe jeweils einen Vorlaufanschluss und einen Rücklaufanschluss für die Einschubgehäuse, insbesondere die Wärmetauscher dieser, aufweisen, wobei die Vorlaufanschlüsse und die Rücklaufanschlüsse über ein jeweiliges Rohrleitungssystem für das Kühlmedium untereinander in Serie geschaltet sind.

Die Rohrleitungssysteme können mit den Vorlaufanschlüssen und den Rücklaufanschlüssen auf einer Montageplatte befestigt sein, wobei die Vorlaufanschlüsse und die Rücklaufanschlüsse als Schnellkupplungen mit senkrecht zur Montageplatte und dementsprechend in Einschubrichtung der Einschubgehäuse ausgerichteter Einsteckrichtung ausgebildet sind, und wobei die Einschubgehäuse an ihrer in der Einschubposition der Montageplatte zugewandten Stirnseite zu den Schnellkupplungen komplementäre Kupplungsgegenstücke aufweisen.

Ein erstes der Rohrleitungssysteme, das die Vorlaufanschlüsse miteinander verbindet, kann mit dem Ausgang des Wärmeübertragers fluidisch verbunden sein, wobei ein zweites der Rohrleitungssysteme, das die Rücklaufanschlüsse miteinander verbindet, mit dem Kühlmediumauslass des Chillers fluidisch verbunden ist.

Eine Kühlanordnung kann einen Chiller der zuvor beschriebenen Art aufweisen sowie einen Kälteverbraucher, beispielsweise eine Werkzeugmaschine mit einer zu kühlenden Komponente, wobei der Kälteverbraucher mit dem Wärmeübertrager, dem Pufferspeicher und einer Pumpe für das Kühlmedium einen Kühlmediumkreislauf bildet. Das Kühlmedium kann dabei über den Wärmeübertrager mit dem Kältemittel des Kompressionskältemittelkreislaufs thermisch gekoppelt sein.

Ein Betriebsverfahren für einen Chiller der zuvor beschriebenen Art kann die folgenden Schritte aufweisen:
- Zirkulieren des Kühlmediums zwischen einem Kälteverbraucher, dem Wärmeübertrager und dem Pufferspeicher;
- Aktivieren des Kompressionskältemittelkreislaufs und Abkühlen des PCM-Materials, bis es eine untere Solltemperatur erreicht hat oder im Wesentlichen vollständig von einem flüssigen in einen festen Aggregatzustand übergegangen ist;
- Deaktivieren des Kompressionskältemittelkreislaufs beim Erreichen der Solltemperatur oder des im Wesentlichen vollständigen festen Aggregatzustands des PCM-Materials; und
- Reaktivieren des Kompressionskältemittelkreislaufs, wenn das PCM-Material eine obere Grenztemperatur überschritten hat oder im Wesentlichen vollständig im flüssigen Aggregatzustand vorliegt.

Weitere Einzelheiten der Erfindung werden anhand der nachstehenden Figuren erläutert. Dabei zeigt:
- Figur 1: in schematischer Darstellung eine Kühlanordnung mit einem Chiller nach dem Stand der Technik;
- Figur 2: in schematischer Darstellung eine Kühlanordnung mit einem Chiller gemäß einer Ausführungsform der Erfindung;
- Figur 3: eine schematische Querschnittsansicht durch ein Rohrleitungssystem eines Wärmetauschers gemäß einer Ausführungsform der Erfindung;
- Figur 4: einen Wärmetauscher unter Verwendung des Rohrleitungssystems gemäß Figur 3 gemäß einer Ausführungsform der Erfindung;
- Figur 5: eine schematische Querschnittsansicht durch ein Einschubgehäuse einer Schaltschrankanordnung;
- Figur 6: eine schematische Ansicht eines Einschubgehäuses in perspektivischer Darstellung;
- Figur 7: eine schematische Darstellung einer Anordnung aus mehreren vertikal übereinander angeordneten Baugruppeneinschüben; und
- Figur 8: ein beispielhaftes Schaltschrankgehäuse einer Schaltschrankanordnung.

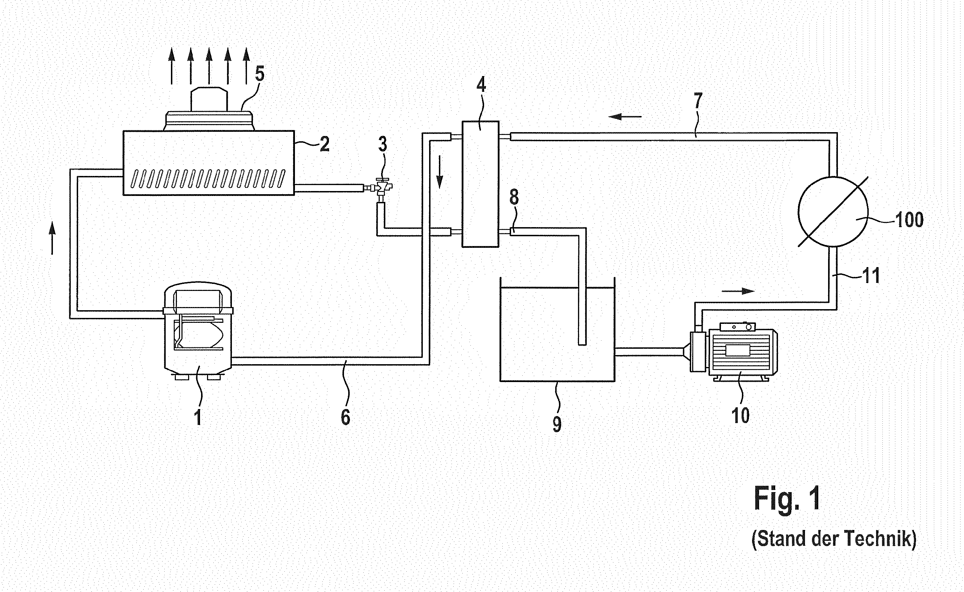

Die Figur 1 zeigt eine beispielhafte Ausführungsform für eine Kühlanordnung unter Verwendung eines Chillers, wie dies aus dem Stand der Technik bekannt ist. Die Kühlanordnung weist einen Kompressionskältemittelkreislauf auf, der fluidisch getrennt über einen Wärmetauscher 4 mit einem Kühlmediumkreislauf für die Kühlung eines Kälteverbrauchers 100, beispielsweise einer Werkzeugmaschine, thermisch gekoppelt ist. Sämtliche Komponenten, bis auf den Kälteverbraucher 100, können in einem gemeinsamen Gehäuse des Chillers aufgenommen sein, wobei das Gehäuse, wie es grundsätzlich aus dem Stand der Technik bekannt ist, Schnittstellen für den Anschluss eines Kühlmediumvorlaufs und eines Kühlmediumrücklaufs für den Kälteverbraucher aufweisen kann.

Der Kompressionskältemittelkreislauf besteht im Wesentlichen aus einem Verdichter 1, einem Verflüssiger 2, einem Expansionsventil 3 und einem Verdampfer 4. Ein Lüfter 5 ist vorgesehen, um Kühlluft durch den als Luft-Kältemittel-Wärmetauscher ausgebildeten Verflüssiger 2 zu transportieren. Der Verdampfer 4 ist ein Wärmeübertrager, um thermische Energie zwischen dem Kompressionskältemittelkreislauf und dem mit dem Kälteverbraucher 100 gebildeten Kühlmediumkreislauf auszutauschen, so dass ein Wärmeaustausch zwischen dem Kältemittel 6 und dem Kühlmedium 7 über den Wärmeübertrager 4 unter gleichzeitiger fluidischer Trennung der beiden Kreisläufe voneinander bereitgestellt ist.

Um die Taktfrequenz des Kompressionskältemittelkreislaufs zu verringern, ist ein Pufferspeicher 9 vorgesehen, welcher ein gewisses Volumen des Kühlmediums 7 vorhält, wodurch die über das Gesamtvolumen des Kühlmediums 7 aufsummierte Wärmekapazität des Kühlmediums 7 entsprechend erhöht ist. Eine Pumpe 10 ist dazu vorgesehen, um das Kühlmedium 7 durch den Kälteverbraucher 100, den Wärmeübertrager 4 und den Pufferspeicher 9 zirkulieren zu lassen. Es ist verständlich, dass bei gegebener Verlustleistung des Kälteverbrauchers 100 die Taktfrequenz des Kompressionskältemittelkreislaufs unmittelbar proportional zu dem Volumen des Pufferspeichers 9 bzw darin enthaltenen Kühlmediums 7 ist. Je größer das Volumen des Pufferspeichers 9, desto größer das Volumen des Kühlmediums 7 und dementsprechend langsamer erhöht sich die Temperatur des Kühlmediums 7 bei gegebener Verlustleistung des Kälteverbrauchers 100.

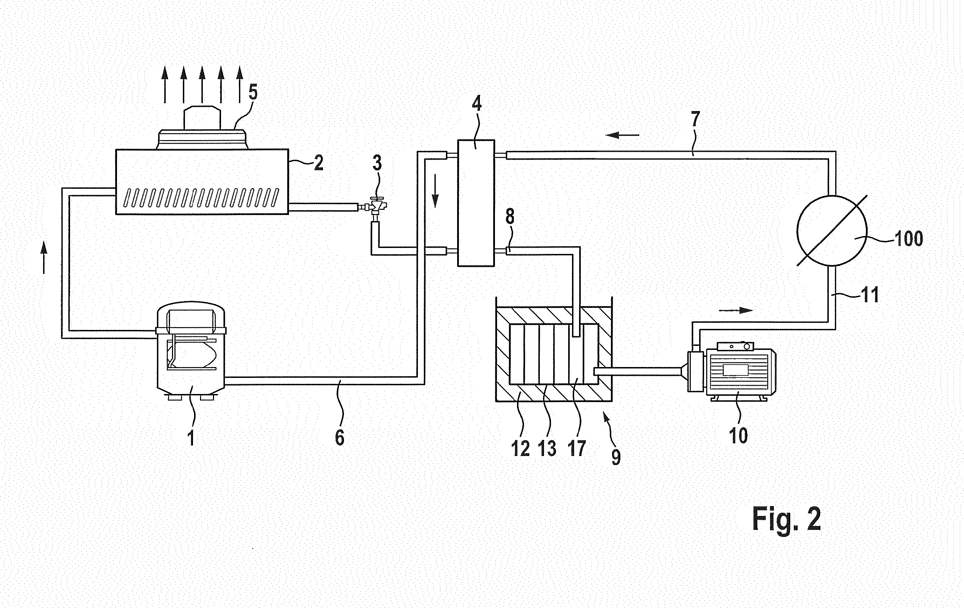

In Abwandlung der in Figur 1 nach dem Stand der Technik gezeigten Anordnung ist bei der in Figur 2 dargestellten Anordnung gemäß einer Ausführungsform der Erfindung zur weiteren Verringerung der Taktrate des Kompressionskältemittelkreislaufs bei gleichzeitig kompakten Bauabmessungen vorgesehen, dass ein PCM-Material 12 in dem Pufferspeicher 9 aufgenommen und das gekühlte, flüssige Kühlmedium in dem Pufferspeicher 9 durch einen Wärmetauscher 13 geleitet ist, über den das gekühlte, flüssige Kühlmedium 7 mit dem PCM-Material 12 thermisch gekoppelt ist. Mit anderen Worten macht sich die Ausführungsform die gegenüber üblichen Kühlmedien 7, wie Öl oder Wasser, erhöhte Wärmekapazität von PCM-Materialien zunutze, so dass bei gegebenen Abmessungen des Pufferspeichers 9 die Taktrate des Kompressionskältemittelkreislaufs wesentlich verringert werden kann, oder, falls eine möglichst kompakte Bauform des Chillers angestrebt wird, die aus dem Stand der Technik bekannten Taktraten bei gleichzeitig verringerter Baugröße des Pufferspeichers 9 und damit des Chillers insgesamt, beibehalten werden können.

Das PCM-Material kann im Wesentlichen das gesamte Volumen des Pufferspeichers 9, welches nicht von dem Wärmetauscher 13 selbst eingenommen wird, einnehmen, und insbesondere können sämtliche Hohlräume 17 zwischen den Lamellen oder Platten des Wärmetauschers 13 von dem PCM-Material 12 gefüllt sein, so dass ein möglichst effektiver Wärmeabtausch zwischen dem PCM-Material 12 und dem Wärmetauscher 13, welcher dementsprechend als Lamellen- oder Plattenwärmetauscher ausgebildet sein kann, gewährleistet ist.

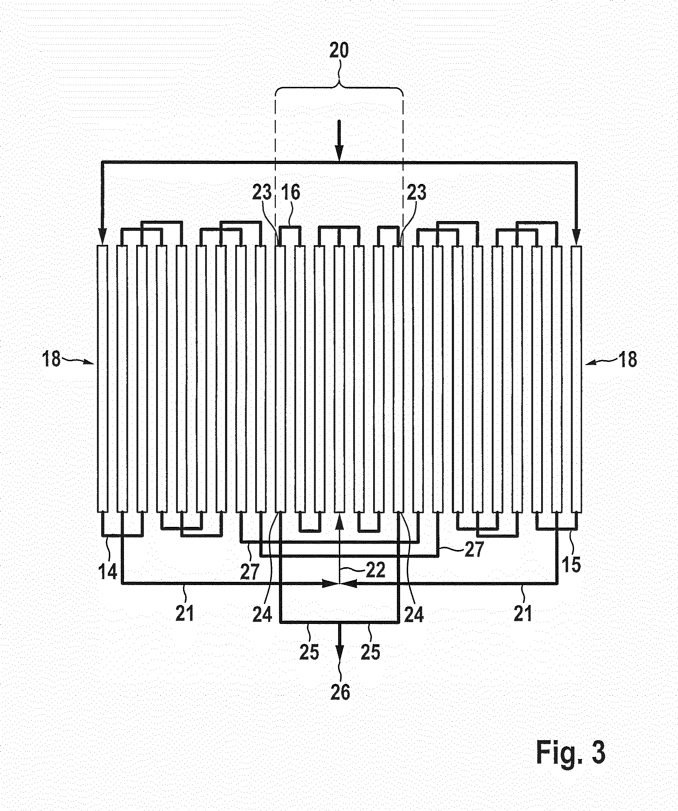

In Figur 3 ist das Rohrleitungssystem 14, 15, 16 eines Wärmetauschers 13 (vergleiche Figur 2) gemäß einer Ausführungsform der Erfindung dargestellt. Um eine optimale Wärmeverteilung im PCM-Material 12 und dementsprechend eine möglichst optimale Rückkühlungswirkung zu erzielen, hat sich herausgestellt, dass das Rohrleitungssystem 14, 15, 16, von dem der Lamellen- oder Plattenwärmetauscher 13 durchsetzt wird, die in Figur 3 gezeigte Leitungsführung zumindest näherungsweise aufweisen sollte. Dazu kann vorgesehen sein, dass das Rohrleitungssystem 14, 15, 16 an gegenüber liegenden Außenseiten 18 des Wärmetauschers jeweils einen Kühlmediumvorlauf 19 aufweist, wobei die Kühlmediumvorläufe 19 über jeweils einen ersten Rohrleitungsabschnitt 14, 15 des Rohrleitungssystems 14, 15 16 mäanderförmig von der jeweiligen Außenseite 18 zu einem zentralen Kernbereich 20 des Wärmetauschers 13 geführt sind.

Es ist weiterhin zu erkennen, dass die beiden ersten Rohrleitungsabschnitte 14, 15 jeweils über den zentralen Kernbereich 20 hinweg mäanderförmig bis zu der jeweils gegenüber liegenden Außenseite 18 geführt sind, wo sie jeweils über Verbindungsleitungen 21 mit einem zweiten Rohrleitungsabschnitt 16 des Rohrleitungssystems 14, 15, 16 im Kernbereich 20 des Wärmetauschers verbunden sind. Insbesondere weisen die beiden ersten Rohrleitungsabschnitte 14, 15 jeweils Sprungleitungen 27 auf, die im Außenbereich des Wärmetauschers geführt sind und den Kernbereich 20 überbrücken, so dass das erste und das zweite Rohrleitungssystem 14, 15 nicht in thermischem Kontakt mit dem PCM-Material im Kernbereich 20 des Wärmetauschers steht.

Der zweite Rohrleitungsabschnitt 16 weist eine zentrale Zuleitung 22 auf, in die die Verbindungsleitungen 21 münden, wobei der zweite Rohrleitungsabschnitt 16 ausgehend von der zentralen Zuleitung 22 mäanderförmig in Richtung der gegenüber liegenden Außenseite 18 geführt ist. Dabei sind an gegenüber liegenden Außengrenzen 23 des Kernbereichs 20 zwei Ausgänge 24 des zweiten Rohrleitungsabschnitts 16 über weitere Verbindungsleitungen 25 mit einem Rücklauf 26 des Wärmetauschers 13 verbunden.

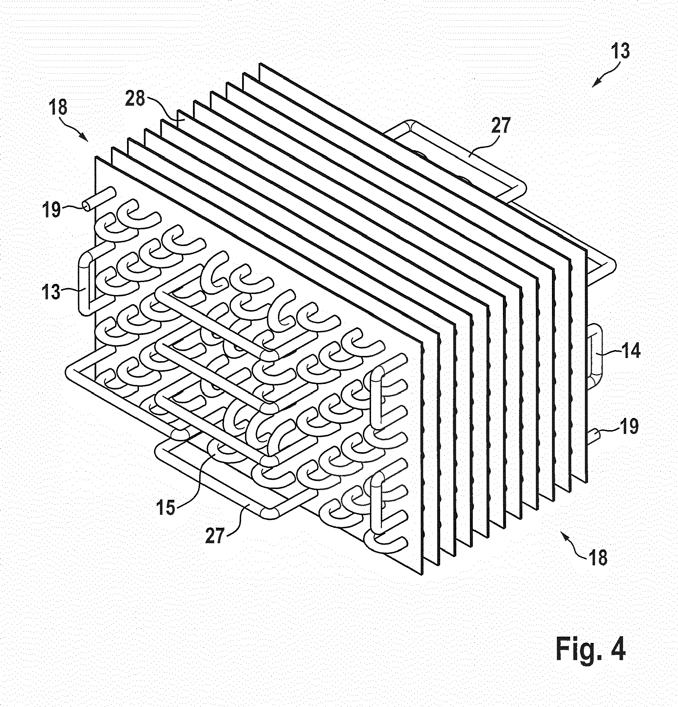

In Figur 4 ist in perspektivischer Darstellung eine beispielhafte Ausführungsform eines Wärmetauschers 13 unter Verwendung des Rohrleitungssystems 14, 15, 16 gemäß Figur 3 gezeigt. Das Rohrleitungssystem 14, 15, 16 weist eine Vielzahl paralleler Lamellen 18 auf, um einen Wärmeabtausch zwischen dem Rohrleitungssystem und dem den Wärmetauscher 13 umgebenden PCM-Material (nicht dargestellt) zu verbessern. Insbesondere sind auch die Sprungleitungen 27 zu erkennen, welche dazu dienen, dass das durch das Rohrleitungssystem 14, 15, 16 geleitete Kühlmedium 7, bevor es im Kernbereich 20 (vgl. Figur 3) das Rohrleitungssystem 14, 15, 16 verlässt, zunächst dem PCM-Material (nicht dargestellt) im Außenbereich des Wärmetauschers 13 thermisch in Kontakt steht. Dadurch wird erreicht, dass das bereits vorgekühlte Kühlmedium 7 zuletzt den Kernbereich des PCM-Materials durchströmt und somit das PCM-Material im Kernbereich des Wärmetauschers 13 bzw. in der Mitte des Pufferspeichers so lange wie möglich in seinem festen Aggregatzustand bleibt und damit den außen liegenden, eventuell bereits verflüssigten Teil kühlt.

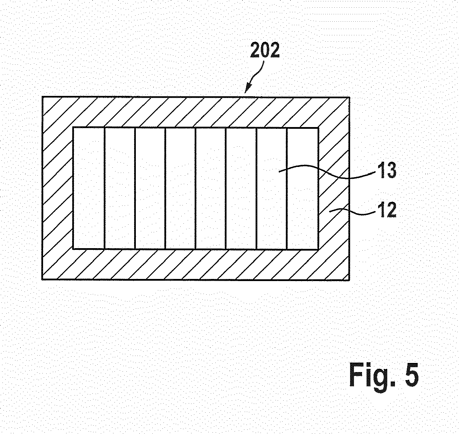

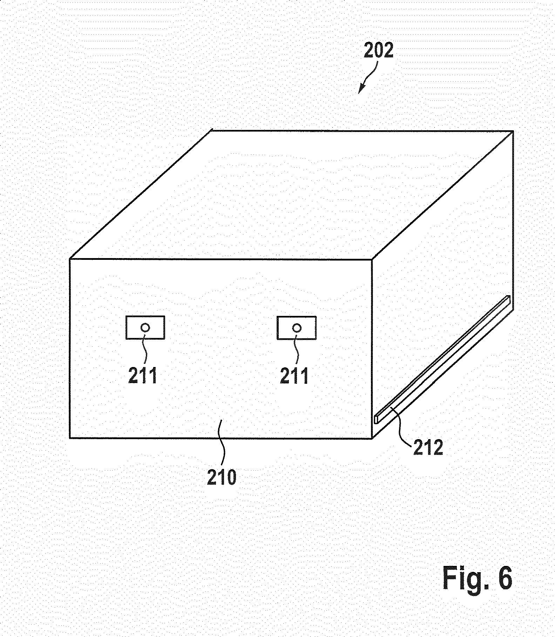

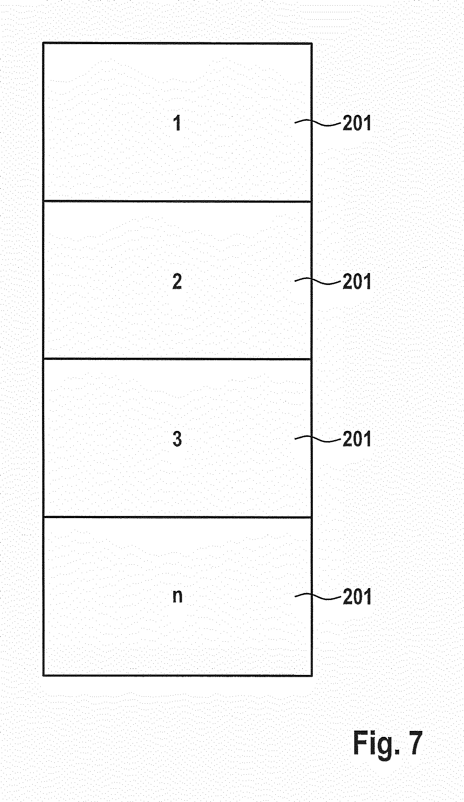

Die Figuren 5 bis 8 zeigen in ihrer Zusammenschau eine Ausführungsform einer Schaltschrankanordnung im Sinne der vorliegenden Erfindung. Die in den einzelnen Figuren gezeigten Komponenten der Anordnung können jedoch auch unabhängig voneinander bei anderen Ausführungsformen zum Einsatz kommen. Demgemäß kann, wie in den Figuren 5 und 6 gezeigt ist, in einem Einschubgehäuse 202 der Wärmetauscher 13 eines Chillers aufgenommen sein, wobei die Innenabmessungen des Einschubgehäuses 202 größer als die Außenabmessungen des Wärmetauschers 13 des Chillers sind, so dass der Wärmetauscher 13 vollständig in PCM-Material 12 eingebettet in dem Inneren des Einschubgehäuses 202 aufgenommen werden kann.

Das Einschubgehäuse kann an zwei gegenüberliegenden Gehäuseseiten, die senkrecht zu einer Stirnseite 210 des Einschubgehäuses 202 stehen, Schienen 212 aufweisen, über die das Einschubgehäuse 202 in entsprechende Baugruppeneinschübe 201 im Inneren eines Schaltschrankgehäuses eingeschoben werden kann. Die Baugruppeneinschübe 201können beispielsweise als 19-Zoll-Einschübe ausgebildet sein. So ist es denkbar, dass eine Mehrzahl Baugruppeneinschübe 201 vertikal übereinander im Inneren eines Schaltschrankgehäuses 200 ausgebildet sind, um bedarfsweise den Pufferspeicher des Chillers zu erweitern oder zu verkleinern.

An der in einer Einschubposition der Einschubgehäuse 202 einer Montageplatte 209 oder einer Backplane zugewandten Stirnseite 210 weist das Einschubgehäuse 202 Kupplungsgegenstücke 211 für einen Vorlauf und einen Rücklauf des in dem Gehäuse 202 aufgenommenen Wärmetauschers 13 auf. Beim Einschieben der Einschubgehäuse 202 in die Einschübe 201 über die Schienen 212 an den gegenüberliegenden Außenseiten des Gehäuses 202 sowie beispielsweise an gegenüberliegenden Innenseiten des Schaltschrankgehäuses 200 oder an einem in dem Schaltschrankgehäuse 200 aufgenommenen 19-Zoll-Rack, können die Einschubgehäuse 202 derart in Bezug auf auf der Montageplatte 209 angeordnete Vorlaufanschlüsse 205 und Rücklaufanschlüsse 206 positioniert werden, dass mit dem Erreichen einer Einschubposition der Einschubgehäuse 202 die Anschlüsse 205, 206 mit den Kupplungsgegenstücken 211 an der Stirnseite 210 in Eingriff gelangen, so dass eine fluidisch dichte Verbindung zwischen dem jeweiligen Einschubgehäuse 202 beziehungsweise des darin aufgenommenen Wärmetauschers 13 und dem Vorlauf 203 sowie dem Rücklauf 204 hergestellt ist. Der Vorlauf 203 ist mit dem Ausgang 8 des Verdampfers 4 (siehe Figur 2) verbunden, während der Rücklauf 204 mit dem Kühlmediumauslass 11 des Chillers beziehungsweise einer zwischengeschalteten Pumpe 10 verbunden ist, entsprechend der Anordnung in Figur 2.

Der Vorlauf 203 und der Rücklauf 204 sind jeweils als vertikale Rohrleitungssysteme 207, 208 ausgebildet, über die die Vorlaufanschlüsse 205 beziehungsweise die Rücklaufanschlüsse 206 in Serie miteinander verbunden sind.

Die Einschubgehäuse 202 können hermetisch verschlossen sein. Zur Steuerung der Pumpe 10 oder anderer Regelorgane, etwa des Expansionsventils, können die Einschubgehäuse 202 mindestens einen Temperaturfühler aufweisen. Die zwischen den Vorlaufanschlüssen 205 beziehungsweise den Rücklaufanschlüssen 206 und den Kupplungsgegenstücken 211 ausgebildeten Kupplungsverbindungen können insbesondere als tropffreie Schnellkupplungen ausgebildet sein.

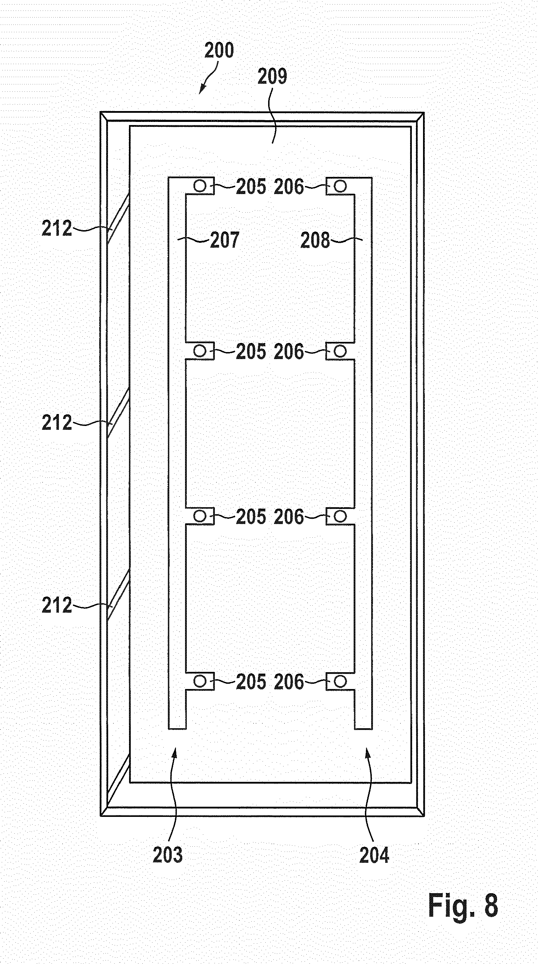

Die in den Figuren 5 bis 8 gezeigte Auslegung erlaubt es, dass bedarfsweise auch mehrere der beispielsweise in Figur 8 gezeigten Schaltschrankgehäuse nebeneinander und mit in Reihe oder parallel verbundenen Rohrleitungssystemen 207, 208 verwendet werden können. Dadurch wird ein platzsparendes System erreicht, bei dem zum einen Primärenergie durch die Nutzung einer witterungsbedingt abgesenkten Umgebungstemperatur beispielsweise unter Verwendung von Freikühlung eingespart werden kann, und zum anderen thermische Lastspitzen gepuffert werden. Indirekt können somit auch elektrische Lasten temporär verschoben werden.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Verdichter
- 2: Verflüssiger
- 3: Expansionsventil
- 4: Verdampfer
- 5: Lüfter
- 6: Kältemittel
- 7: Kühlmedium
- 8: Ausgang
- 9: Pufferspeicher
- 10: Pumpe
- 11: Kühlmediumauslass
- 12: PCM-Material
- 13: Wärmetauscher
- 14, 15: erste Rohrleitungsabschnitte
- 16: zweiter Rohrleitungsabschnitt
- 17: Hohlraum
- 18: Außenseite
- 19: Kühlmediumvorlauf
- 20: Kernbereich
- 21: Verbindungsleitung
- 22: Zuleitung
- 23: Außengrenze
- 24: Ausgang
- 25: Verbindungsleitung
- 26: Rücklauf
- 27: Stromleitung
- 28: Lamelle
- 100: Kälteverbraucher
- 200: Schaltschrankgehäuse
- 201: Baugruppeneinschub
- 202: Einschubgehäuse
- 203: Vorlauf
- 204: Rücklauf
- 205: Vorlaufanschluss
- 206: Rücklaufanschluss
- 207: Rohrleitungssystem des Vorlaufs
- 208: Rohrleitungssystem des Rücklaufs
- 209: Montageplatte
- 210: Stirnseite
- 211: Kupplungsgegenstück
- 212: Schiene

## Patentansprüche

1. Chiller für die Kühlung eines flüssigen Kühlmediums, wobei der Chiller einen Kompressionskältemittelkreislauf mit einem Verdichter (1), einem Verflüssiger (2), einem Expansionsventil (3) und einem Verdampfer (4) aufweist, wobei der Verdampfer (4) ein Wärmeübertrager ist, über den ein Kältemittel (6) des Kompressionskältemittelkreislaufs mit einem zu kühlenden flüssigen Kühlmedium (7) fluidisch getrennt thermisch gekoppelt ist, wobei ein Ausgang (8) des Wärmeübertragers (4) für gekühltes, flüssiges Kühlmedium (7) in mindestens einen Speicher (9) mündet und das gekühlte, flüssige Kühlmedium (7) aus dem Speicher (9) einem Kühlmediumauslass (11) des Chillers zugeleitet ist, **dadurch gekennzeichnet, dass** der Speicher (9) ein Pufferspeicher (9) ist, und dass ein PCM-Material (12) in dem Pufferspeicher (9) aufgenommen und das gekühlte flüssige Kühlmedium (7) in dem Pufferspeicher (9) durch einen Wärmetauscher (13) geleitet ist, über den das gekühlte, flüssige Kühlmedium (7) mit dem PCM-Material (12) thermisch gekoppelt ist.

2. Chiller nach Anspruch 1, bei dem entweder
- der Wärmetauscher (13) ein Lamellen- oder Plattenwärmetauscher mit einem Rohrleitungssystem ist, durch das das gekühlte, flüssige Kühlmedium (7) geleitet ist, wobei das PCM-Material (12) den Lamellen- oder Plattenwärmetauscher umgibt; oder
- bei dem das PCM-Material (12) als mehrere PCM-Materialkapseln bereitgestellt ist, mit jeweils einem PCM-Materialkern, der von einem doppelwandigen und von dem Kühlmedium durchströmten Rohrmantel vollständig umschlossen ist.

3. Chiller nach Anspruch 2, bei dem, wenn das PCM-Material (12) als mehrere PCM-Materialkapseln bereitgestellt ist, die Rohrmäntel der mehreren PCM-Materialkapseln fluidisch in Reihe oder parallel geschaltet sind.

4. Chiller nach einem der vorangegangenen Ansprüche, bei dem der Wärmetauscher (13) in dem Pufferspeicher (9) ein Lamellen- oder Plattenwärmetauscher mit parallel beabstandeten Wärmetauscherlamellen oder -platten ist, der von einem Rohrleitungssystem (14, 15, 16) durchsetzt ist, durch das das Kühlmedium (7) geleitet ist, wobei das PCM-Material (12) in Hohlräumen (17) zwischen den Lamellen (28) oder Platten aufgenommen ist und/oder die Lamellen (28) oder Platten hohl ausgebildet sind, mit zwischen gegenüber liegenden Wandungen eingeschlossenem PCM-Material (12).

5. Chiller nach einem der vorangegangenen Ansprüche, bei dem der Wärmetauscher (13) in dem Pufferspeicher (9) von einem Rohrleitungssystem (14, 15, 16) durchsetzt ist, durch das das Kühlmedium (7) geleitet ist, wobei das Rohrleitungssystem (14, 15, 16) an gegenüber liegenden Außenseiten (18) des Wärmetauschers (13) jeweils einen Kühlmediumvorlauf (19) aufweist, wobei die Kühlmediumvorläufe (19) über jeweils einen ersten Rohrleitungsabschnitt (14, 15) des Rohrleitungssystems (14, 15, 16) mäanderförmig von den Außenseiten (18) zu einem zentralen Kernbereich (20) des Wärmetauschers (13) geführt sind.

6. Chiller nach Anspruch 5, bei dem die beiden ersten Rohrleitungsabschnitte (14, 15) jeweils über den zentralen Kernbereich (20) hinweg mäanderförmig bis zu der jeweils gegenüber liegenden Außenseite (18) geführt sind, wo sie jeweils über Verbindungsleitungen (21) mit einem zweiten Rohrleitungsabschnitt (16) des Rohrleitungssystems (14, 15, 16) im Kernbereich (20) des Wärmetauschers (13) verbunden sind, wobei die beiden ersten Rohrleitungsabschnitte (14, 15) vorzugsweise den Kernbereich (20) mittels Sprungleitungen (27) überbrücken.

7. Chiller nach Anspruch 6, bei dem der zweite Rohrleitungsabschnitt (16) eine zentrale Zuleitung (22) aufweist, in die die Verbindungsleitungen (21) münden, wobei der zweite Rohrleitungsabschnitt (16) ausgehend von der zentralen Zuleitung (22) mäanderförmig in Richtung der gegenüber liegenden Außenseite (18) geführt ist.

8. Chiller nach Anspruch 7, bei dem an gegenüberliegenden Außengrenzen (23) des Kernbereichs (20) zwei Ausgänge (24) des zweiten Rohrleitungsabschnitts (16) über weitere Verbindungsleitungen (25) mit einem Rücklauf (26) des Wärmetauschers (13) verbunden sind.

9. Kühlanordnung mit einem Chiller nach einem der vorangegangen Ansprüche und einem Kälteverbraucher (100), der mit dem Wärmeübertrager (4), dem Pufferspeicher (9) und einer Pumpe (10) für das Kühlmedium (7) einen Kühlmediumkreislauf bildet, wobei das Kühlmedium (7) über den Wärmeübertrager (4) mit dem Kältemittel (6) des Kompressionskältemittelkreislaufs thermisch gekoppelt ist.

10. Schaltschrankanordnung, die einen Chiller nach einem der Ansprüche 1 bis 8 sowie ein Schaltschrankgehäuse (200) mit mindestens einem Baugruppeneinschub (201), insbesondere mindestens einem 19"-Einschub, wobei der Pufferspeicher (9) mindestens ein in einen der Baugruppeneinschübe (201) eingeschobenes und wahlweise daraus wieder entnehmbares Einschubgehäuse (202) ist, in dem der Wärmetauscher (13) und das PCM-Material (12) aufgenommen sind.

11. Schaltschrankanordnung nach Anspruch 10, bei der das mindestens eine Einschubgehäuse (202), insbesondere der Wärmetauscher (13), in einer Einschubposition, in der das Einschubgehäuse (202) vollständig in den Baugruppeneinschub (201) eingeschoben ist, einen Vorlauf (203) und einen Rücklauf (204) für das gekühlte, flüssige Kühlmedium (7) fluidisch kontaktiert.

12. Schaltschrankanordnung nach Anspruch 10 oder 11, bei der das Schaltschrankgehäuse (200) mehrere vertikal übereinander und/oder horizontal nebeneinander angeordnete Baugruppeneinschübe (201) und mehrere darin aufgenommene Einschubgehäuse (202) aufweist, wobei die Baugruppeneinschübe (201) jeweils einen Vorlaufanschluss (205) und einen Rücklaufanschluss (206) für die Einschubgehäuse (202), insbesondere die Wärmetauscher (13) dieser, aufweisen, wobei die Vorlaufanschlüsse (205) und die Rücklaufanschlüsse (206) über ein jeweiliges Rohrleitungssystem (207, 208) für das Kühlmedium (7) untereinander in Serie geschaltet sind.

13. Schaltschrankanordnung nach Anspruch 12, bei der die Rohrleitungssysteme (207, 208) mit den Vorlaufanschlüssen (205) und den Rücklaufanschlüssen (206) auf einer Montageplatte (209) befestigt sind, wobei die Vorlaufanschlüsse (205) und die Rücklaufanschlüsse (206) als Schnellkupplungen mit senkrecht zur Montageplatte (209) und dementsprechend in Einschubrichtung der Einschubgehäuse (202) ausgerichteter Einsteckrichtung ausgebildet sind, und wobei die Einschubgehäuse (202) an ihrer in der Einschubposition der Montageplatte (209) zugewandten Stirnseite (210) zu den Schnellkupplungen komplementäre Kupplungsgegenstücke (211) aufweisen.

14. Schaltschrankanordnung nach Anspruch 12 oder 13, bei der ein erstes der Rohrleitungssysteme (207, 208), das die Vorlaufanschlüsse (205) miteinander verbindet, mit dem Ausgang (8) des Wärmeübertragers (4) fluidisch verbunden ist, und wobei ein zweites der Rohrleitungssysteme (207, 208), das die Rücklaufanschlüsse (206) miteinander verbindet, mit dem Kühlmediumauslass (11) des Chillers fluidisch verbunden ist.

15. Betriebsverfahren für einen Chiller oder eine Schaltschrankanordnung nach einem der Ansprüche 1 bis14, das die Schritte aufweist:
- Zirkulieren des Kühlmediums (7) zwischen einem Kälteverbraucher (100), dem Wärmeübertrager (4) und dem Pufferspeicher (9);
- Aktivieren des Kompressionskältemittelkreislaufs und Abkühlen des PCM-Materials (12), bis es eine untere Solltemperatur erreicht hat oder im Wesentlichen vollständig von einem flüssigen in einen festen Aggregatzustand übergegangen ist;
- Deaktivieren des Kompressionskältemittelkreislaufs beim Erreichen der Solltemperatur oder des im Wesentlichen vollständigen festen Aggregatzustands des PCM-Materials (12); und
- Reaktivieren des Kompressionskältemittelkreislaufs, wenn das PCM-Material (12) eine obere Grenztemperatur überschritten hat oder im Wesentlichen vollständig im flüssigen Aggregatzustand vorliegt.

## Claims

1. A chiller for cooling a liquid cooling medium, the chiller having a compression refrigerant circuit with a compressor (1), a condenser (2), an expansion valve (3) and an evaporator (4), the evaporator (4) being a heat exchanger device via which a refrigerant (6) of the compression refrigerant circuit is fluidically separate thermally coupled to a liquid cooling medium (7) to be cooled, an outlet (8) of the heat exchanger device (4) for the cooled liquid cooling medium (7) opens into at least one storage and the cooled liquid cooling medium (7) is supplied from the storage to a cooling medium outlet (11) of the chiller, **characterized in that** the storage is a buffer storage (9), and **in that** a PCM material (12) is received in the buffer storage (9) and the cooled liquid cooling medium (7) is passed in the buffer storage (9) through a heat exchanger (13) via which the cooled liquid cooling medium (7) is thermally coupled to the PCM material (12).

2. The chiller according to claim 1, in which either
- the heat exchanger (13) is a lamella or plate heat exchanger having a piping system through which the cooled liquid cooling medium (7) is conducted, wherein the PCM material (12) surrounds the lamella or plate heat exchanger; or
- in which the PCM material (12) is provided as a plurality of PCM material capsules, each having a PCM material core which is completely enclosed by a double-walled pipe jacket through which the cooling medium flows.

3. The chiller according to claim 2, wherein when the PCM material (12) is provided as a plurality of PCM material capsules, the tube jackets of the plurality of PCM material capsules are fluidically connected in series or in parallel.

4. The chiller according to any of the preceding claims, in which the heat exchanger (13) in the buffer storage (9) is a lamella or plate heat exchanger with parallel spaced heat exchanger lamellae or plates, which is penetrated by a piping system (14, 15, 16), through which the cooling medium (7) is conducted, the PCM material (12) being received in cavities (17) between the lamellae (28) or plates and/or the lamellae (28) or plates being hollow, with PCM material (12) enclosed between opposing walls.

5. The chiller according to one of the preceding claims, in which the heat exchanger (13) in the buffer store (9) is penetrated by a piping system (14, 15, 16) through which the cooling medium (7) is conducted, the piping system (14, 15, 16) each having a cooling medium feed (19) on opposite outer sides (18) of the heat exchanger (13), the cooling medium feeds (19) being guided meanderingly from the outer sides (18) to a central core region (20) of the heat exchanger (13) via a first pipeline section (14, 15) of the piping system (14, 15, 16) each.

6. The chiller according to claim 5, in which the two first pipeline sections (14, 15) are each guided meanderingly over the central core region (20) up to the respective opposite outer side (18), where they are each connected via connecting lines (21) to a second pipeline section (16) of the piping system (14, 15, 16) in the core region (20) of the heat exchanger (13), the two first pipeline sections (14, 15) preferably bridging the core region (20) by means of jump lines (27).

7. The chiller according to claim 6, in which the second pipeline section (16) has a central feed line (22) into which the connecting lines (21) open, the second pipeline section (16) being guided in a meandering manner in the direction of the opposite outer side (18) starting from the central feed line (22).

8. The chiller according to claim 7, in which two outlets (24) of the second pipeline section (16) are connected to a return line (26) of the heat exchanger (13) via further connecting lines (25) at opposite outer perimeters (23) of the core region (20).

9. A cooling arrangement having a chiller according to any of the preceding claims and a cooling consumer (100) which forms a cooling medium circuit with the heat exchanger device (4), the buffer storage (9) and a pump (10) for the cooling medium (7), the cooling medium (7) being thermally coupled to the refrigerant (6) of the compression refrigerant circuit via the heat exchanger device (4).

10. A switchgear cabinet arrangement which comprises a chiller according to any of claims 1 to 8 and a switchgear cabinet housing (200) having at least one module insert (201), in particular at least one 19" insert, the buffer storage (9) being at least one module housing (202) which is inserted into one of the module inserts (201) and optionally removable therefrom and in which the heat exchanger (13) and the PCM material (12) are accommodated.

11. The switchgear cabinet arrangement according to claim 10, in which the at least one module housing (202), in particular the heat exchanger (13), in an insert position, in which the module housing (202) is completely inserted into the module insert (201), fluidically contacts a supply line (203) and a return line (204) for the cooled liquid cooling medium (7).

12. The switchgear cabinet arrangement according to claim 10 or 11, in which the switchgear cabinet housing (200) has a plurality of module inserts (201) arranged vertically one above the other and/or horizontally next to one another and a plurality of module housings (202) accommodated therein, the module inserts (201) each having a supply line connection (205) and a return line connection (206) for the module housings (202), in particular the heat exchangers (13) thereof, the supply line connections (205) and the return line connections (206) being connected in series with one another via a respective pipeline system (207, 208) for the cooling medium (7).

13. The switchgear cabinet arrangement according to claim 12, in which the pipeline systems (207, 208) with the supply line connections (205) and the return line connections (206) are fastened on a mounting plate (209), wherein the supply line connections (205) and the return line connections (206) are designed as quick couplings with an insertion direction oriented perpendicularly to the mounting plate (209) and correspondingly in the insertion direction of the module housing (202), and the module housings (202) having on their front face (210) facing the mounting plate (209) in the insert position complementary coupling counterparts (211) to the quick couplings.

14. The switchgear cabinet arrangement according to claim 12 or 13, in which a first of the pipeline systems (207, 208), which connects the supply line connections (205), is fluidically connected to the outlet (8) of the heat exchanger device (4), and a second of the pipeline systems (207, 208), which connects the return line connections (206), is fluidically connected to the cooling medium outlet (11) of the chiller.

15. A method for operating a chiller or switchgear cabinet arrangement according to any of claims 1 to 14, comprising the steps:
- circulating the cooling medium (7) between a cooling consumer (100), the heat exchanger device (4) and the buffer storage (9);
- activating the compression refrigerant circuit and cooling the PCM material (12) until it has reached a lower target temperature or has substantially completely changed from a liquid to a solid state of aggregation;
- deactivating the compression refrigerant circuit upon reaching the target temperature or substantially complete solid state of aggregation of the PCM material (12); and
- reactivating the compression refrigerant circuit when the PCM material (12) has exceeded an upper limit temperature or is substantially completely in the liquid state.

## Revendications

1. Refroidisseur pour le refroidissement d'un milieu de refroidissement liquide, le refroidisseur comprenant un circuit de réfrigérant à compression avec un compresseur (1), un condenseur (2), une soupape d'expansion (3) et un évaporateur (4), l'évaporateur (4) étant un échangeur thermique par l'intermédiaire duquel un réfrigérant (6) du circuit de réfrigérant à compression est couplé thermiquement, de manière séparée fluidiquement, avec un milieu de refroidissement liquide (7) à refroidir, une sortie (8) de l'échangeur thermique (4) pour un milieu de refroidissement liquide (7) refroidi débouchant dans au moins un accumulateur (9) et le milieu de refroidissement liquide (7) refroidi étant introduit de l'accumulateur (9) vers une sortie de milieu de refroidissement (11) du refroidisseur, **caractérisé en ce que** l'accumulateur (9) est un accumulateur tampon (9) et **en ce que**
un matériau PCM (12) est logé dans l'accumulateur tampon (9) et le milieu de refroidissement liquide (7) refroidi est conduit dans l'accumulateur tampon (9) par un échangeur thermique (13), par l'intermédiaire duquel le milieu de refroidissement liquide (7) refroidi est couplé thermiquement avec le matériau PCM (12).

2. Refroidisseur selon la revendication 1, dans lequel soit :
- l'échangeur thermique (13) est un échangeur thermique à lamelles ou à plaques avec un système de canalisations, grâce auquel le milieu de refroidissement liquide (7) refroidi est guidé, le matériau PCM (12) entourant l'échangeur thermique à lamelles ou à plaques ; soit
- dans lequel le matériau PCM (12) est réalisé sous la forme de plusieurs capsules de matériau PCM avec chacune un noyau de matériau PCM qui est entièrement entouré d'une enveloppe tubulaire à double paroi et traversée par le milieu de refroidissement.

3. Refroidisseur selon la revendication 2, dans lequel, lorsque le matériau PCM (12) est réalisé sous la forme de plusieurs capsules de matériau PCM, les enveloppes tubulaires des plusieurs capsules de matériau PCM sont branchées fluidiquement en série ou en parallèle.

4. Refroidisseur selon l'une des revendications précédentes, dans lequel l'échangeur thermique (13) dans l'accumulateur tampon (9) est un échangeur thermique à lamelles ou à plaques avec des lamelles ou des plaques d'échangeur thermique distantes parallèles, qui est traversé par un système de canalisations (14, 15, 16) par lequel le milieu de refroidissement (7) est guidé, le matériau PCM (12) étant logé dans des cavités (17) entre les lamelles (28) ou les plaques et/ou les lamelles (28) ou les plaques étant creuses, avec du matériau PCM (12) inclus dans des parois opposées.

5. Refroidisseur selon l'une des revendications précédentes, dans lequel l'échangeur thermique (13) dans l'accumulateur tampon (9) est traversé par un système de canalisations (14, 15, 16) par lequel le milieu de refroidissement (7) est guidé, le système de canalisations (14, 15, 16) comprenant, sur chacun des côtés externes (18) opposés de l'échangeur thermique (13), un circuit aller de milieu de refroidissement (19), les circuits aller de milieu de refroidissement (19) étant guidés chacun par l'intermédiaire d'une première portion de canalisation (14, 15) du système de canalisations (14, 15, 16) en zigzag des côtés externes (18) vers une partie de noyau centrale (20) de l'échangeur thermique (13).

6. Refroidisseur selon la revendication 5, dans lequel les deux premières portions de canalisations (14, 15) sont guidées chacune au-delà de la partie de noyau centrale (20) en zigzag jusqu'au côté externe (19) opposé correspondant, où elles sont reliées chacune par l'intermédiaire de conduites de liaison (21) avec une deuxième portion de canalisation (16) du système de canalisations (14, 15, 16) dans la partie de noyau centrale (20) de l'échangeur thermique (13), les deux premières portions de canalisations (14, 15) pontant de préférence la partie de noyau (20) au moyen de conduites de dérivation (27).

7. Refroidisseur selon la revendication 6, dans lequel la deuxième portion de canalisation (16) comprend une conduite d'alimentation centrale (22) dans laquelle débouchent les conduites de liaison (21), la deuxième portion de canalisation (16) étant guidée, à partir de la conduite d'alimentation centrale (22) en zigzag en direction du côté externe (18) opposé.

8. Refroidisseur selon la revendication 7, dans lequel, au niveau de limites externes (23) opposées de la partie de noyau (20), deux sorties (24) de la deuxième portion de canalisation (16) sont reliées par l'intermédiaire de conduites de liaison supplémentaires (25) avec un retour (26) de l'échangeur thermique (13).

9. Disposition de refroidissement avec un refroidisseur selon l'une des revendications précédentes et un consommateur de froid (100), qui constitue, avec l'échangeur thermique (4), l'accumulateur tampon (9) et une pompe (10) pour le milieu de refroidissement (7), un circuit de réfrigérant, le milieu de refroidissement (7) étant couplé thermiquement par l'intermédiaire de l'échangeur thermique (4) avec le réfrigérant (6) du circuit de réfrigérant à compression.

10. Disposition d'armoire de commande qui comprend un refroidisseur selon l'une des revendications 1 à 8 ainsi qu'un boîtier d'armoire de commande (200) avec au moins une baie de sous-ensemble (201), plus particulièrement au moins une baie 19", l'accumulateur tampon (9) étant au moins un boîtier insérable (202) dans lequel l'échangeur thermique (13) et le matériau PCM (12) sont logés.

11. Disposition d'armoire de commande selon la revendication 10, dans laquelle l'au moins un boîtier insérable (202), plus particulièrement l'échangeur thermique (13), dans une position d'insertion dans laquelle le boîtier insérable (202) est entièrement inséré dans la baie de sous-ensemble (201), met en contact fluidique un aller (203) et un retour (204) pour le milieu de refroidissement liquide (7) refroidi.

12. Disposition d'armoire de commande selon la revendication 10 ou 11, dans laquelle le boîtier d'armoire de commande (200) comprend plusieurs baies de sous-ensembles (201) superposées verticalement et/ou juxtaposées horizontalement et plusieurs boîtiers insérables (202) logés à l'intérieur, les baies de sous-ensembles (201) comprenant chacune un raccord aller (205) et un raccord retour (206) pour les boîtiers insérables (202), plus particulièrement les échangeurs thermiques de ceux-ci, les raccords aller (205) et les raccords retour (206) étant branchés entre eux en série par l'intermédiaire d'un système de canalisation (207, 208) respectif pour le milieu de refroidissement (7).

13. Disposition d'armoire de commande selon la revendication 12, dans laquelle les systèmes de canalisations (207, 208) sont fixés avec les raccords aller (205) et les raccords retour (206) sur une plaque de montage (209), les raccords aller (205) et les raccords retour (206) étant conçus comme des couplages rapides avec une direction d'enfichage orientée perpendiculairement à la plaque de montage (209) et par conséquent dans la direction d'insertion des boîtiers insérables (202), et les boîtiers insérables (202) comprenant, au niveau de leur face frontale (210) orientée vers la plaque de montage (209), dans la position d'insertion, des contre-pièces de couplage (211) complémentaires des couplages rapides.

14. Disposition d'armoire de commande selon la revendication 12 ou 13, dans laquelle un premier des systèmes de canalisations (207, 208), qui relie entre eux les raccords aller (205), est relié de manière fluidique avec la sortie (8) de l'échangeur thermique (4) et un deuxième des systèmes de canalisations (207, 208), qui relie entre eux les raccords retour (206), est relié de manière fluidique avec la sortie de milieu de refroidissement (11) du refroidisseur.

15. Procédé d'exploitation pour un refroidisseur ou une disposition d'armoire de commande selon l'une des revendications 1 à 14, comprenant les étapes suivantes :
- circulation du milieu de refroidissement (7) entre un consommateur de froid (100), l'échangeur thermique (4) et l'accumulateur tampon (9) ;
- activation du circuit de réfrigérant à compression et refroidissement du matériau PCM (12) jusqu'à ce qu'il ait atteint une température de consigne inférieure ou soit passé globalement entièrement d'un état liquide vers état solide ;
- désactivation du circuit de réfrigérant à compression lorsque la température de consigne ou l'état globalement entièrement solide du matériau PCM (12) sont atteints ; et
- réactivation du circuit de réfrigérant à compression lorsque le matériau PCM (12) a dépassé une température limite supérieure ou existe globalement entièrement dans un état liquide.
